Europäisches Patentamt

European Patent Office

Office européen des brevets

(19)

(11) Publication number: **0 022 355**
**B1**

(12) **EUROPEAN PATENT SPECIFICATION**

(45) Date of publication of patent specification: **18.04.84**

(51) Int. Cl.³: **H 01 L 29/743**

(21) Application number: **80302258.1**

(22) Date of filing: **03.07.80**

(54) Gate turn-off thyristor.

(30) Priority: **06.07.79 JP 84964/79**

(43) Date of publication of application:
**14.01.81 Bulletin 81/2**

(45) Publication of the grant of the patent:
**18.04.84 Bulletin 84/16**

(84) Designated Contracting States:
**CH DE FR GB LI NL SE**

(56) References cited:
**EP - A - 0 009 367**
**DE - A - 2 064 110**
**DE - B - 2 055 353**
**FR - A - 2 185 860**
**GB - A - 1 314 985**
**US - A - 3 504 242**

(73) Proprietor: **Hitachi, Ltd.**
**5-1, Marunouchi 1-chome**
**Chiyoda-ku Tokyo 100 (JP)**

(72) Inventor: **Shimizu, Yoshiteru**
**120-1 Higashiishikawa**
**Katsuta Ibaraki (JP)**
Inventor: **Nagano, Takahiro**
**2693-5 Kanesawa**
**Hitachi Ibaraki (JP)**
Inventor: **Sakurada, Shuroku**
**1-6-2-405 Nishinarusawa**
**Hitachi Ibaraki (JP)**
Inventor: **Ohta, Takehiro**
**1-33-1 Nishinarusawa**
**Hitachi Ibaraki (JP)**

(74) Representative: **Calderbank, Thomas Roger et al,**
**MEWBURN ELLIS & CO. 2/3 Cursitor Street**
**London EC4A 1BQ (GB)**

Courier Press, Leamington Spa, England.

Gate turn-off thyristor

The present invention relates to a gate turn-off thyristor (commonly known as a GTO and hereinafter referred to as a GTO thyristor).

A GTO thyristor of the PNPN four-layer construction type with a control electrode is capable of controlling large quantities of electric power, in comparison with transistors. A GTO thyristor has been proposed which is equipped with an emitter short-circuiting layer on the anode side to enhance its gate turn-off ability, (see for example, Figs. 6 and 7 of U.S. Patent No. 3,239,728).

A GTO consists of four semiconductor layers, two outer layers and two inner layers with the conductivity type of each layer being different from the conductivity type of the or each contiguous layer. An anode contacts one of the outer layers, a cathode contacts the other outer layer and a control or gate electrode contacts one of the inner layers. A voltage is applied between the anode and cathode and the device is turned on and off (from non-conducting to conducting and vice versa) by application of suitable voltages to the gate.

It is known to improve the turn-off time of a GTO by shorting the inner layer not contacted by the gate (the first inner layer) to the anode. Such a GTO, corresponding to the prior art part of claim 1, was disclosed by Okamura et al. in the 1977 IEEE/IAS International Semiconductor Power Converter Conference of 28th to 31st March 1977, the conference record of which was published in 1977. The GTO disclosed had the outer layer contacted by the cathode (the second outer layer) divided into a plurality of elongate units extending parallel to each other. The parts of the outer layer contacted by the anode (the first outer layer) similarly form elongate units.

However, the inventors of the present invention have found a problem with such a structure. The device is turned off by applying a signal to a lead connected to the gate electrode and this lead is nearer to one end of the elongate units of the second outer layer than the other end. At the fast turn-off times achievable with this device there is a delay in turn-off along the elongate units of the second outer layer i.e. turn-off occurs at the end of the unit nearest the gate electrode lead before turn off at the end furthest from that lead. This causes a concentration of current at the end of the elongate unit furthest from the lead which can result in damage to the device.

It has now been found that this defect occurring on the cathode side can be compensated for by suitable design of the anode side shorting. Thus the present invention proposes making the first portion or portions of the first inner layer which contact the anode so that they surround, when seen in plan view, the elongate units of the first outer layer and have elongate regions which increase in width per unit length in the direction of their elongation from first ends of the elongate units of the first outer layer to second ends of those units. The control electrode connection member (lead to gate) is then connected to the control electrode at a point spaced away from the first ends of the elongate units of the second outer layer (these first ends corresponding in plan view to the first ends of the units of the first outer layer) in the opposite direction to the direction of elongation of the units of the second outer layer from the first ends thereof to second ends thereof.

As explained in more detail below, the widening of the shorting parts of the first inner layer compensates for the delay of turn off along the elongate units of the second outer layer so that turn-off is uniform.

The present invention permits (but does not require) the units of the second outer layer to be arranged in a radial pattern. The lead is then located approximately centrally in that radial arrangement. This radial arrangement permits simultaneous turn-off of each unit of the second outer layer. This advantage of a radial pattern is mentioned in GB—A—1,314,985, from which document features, a, b, c, d, e, f and j of claim 1 are known.

When the GTO thyristor is turned off, therefore, the carriers can be extracted without difficulty, and the current which flows through the semiconductor body or elements does not concentrate at one region in the semiconductor body or element. Consequently, the GTO thyristor is not liable to thermal destruction, and a high power handling capacity can be obtained.

The preferred embodiments of the invention are described below by way of example with reference to the accompanying drawings, in which:—

Fig. 1 is a graph illustrating relationships between the emitter short-circuited resistance $R_{so}$ and the turn-off time $t_q$ of an emitter short-circuited GTO thyristor;

Fig. 2 is a top plan view illustrating the pattern on the cathode side of a GTO thyristor according to the present invention;

Fig. 3 is a partial cross-sectional view on the line A—A' of Fig. 2;

Fig. 4 is a diagram illustrating the arrangement of the gate lead wire of the GTO thyristor of Fig. 2;

Fig. 5 is a graph illustrating the variation of turn-off times caused by the formation of the emitter layer on the cathode side as radially extending elongate units;

Fig. 6 is a graph illustrating the variation of turn-off times obtained when the emitter short-circuiting layer on the anode side is formed in a wedge shape;

Fig. 7 is a cross-sectional perspective view of the region B of the thyristor of Fig. 2;

Fig. 8 is a plan view of a modified embodiment of GTO thyristor according to the present invention showing three GTO units;

Fig. 9 is cross-sectional views of a portion of the cathode side in several GTO thyristors according to the present invention;

Fig. 10 is a vertical cross-sectional view of a GTO unit in a further embodiment of the present invention; and

Fig. 11 is a cross-sectional view of a GTO unit, in yet another embodiment of the present invention.

In an emitter short-circuited GTO thyristor having a small emitter short-circuiting resistance, the carriers accumulated in the first base layer can be quickly driven into the emitter short-circuiting layer when the device is turned off, thus shortening the turn-off time. If the emitter short-circuiting resistance is decreased, however, the amount of hole injection from the emitter junction $J_1$ on the anode side into the first base layer is reduced when the device is turned on; the on-state voltage is increased and a major portion of the current of the thyristor becomes a short-circuit current, so that the device is no longer capable of retaining the conductive state.

An optimum value of the emitter short-circuiting resistance thus exists which determines the emitter short-circuiting effect. This resistance $R_{so}$ is given by the following relation

$$R_{so} = K \, \rho n \, W \qquad (1)$$

where K denotes the shape factor of the emitter pattern, $\rho n$ denotes the resistivity of the first base layer, and W denotes the thickness of the first base layer.

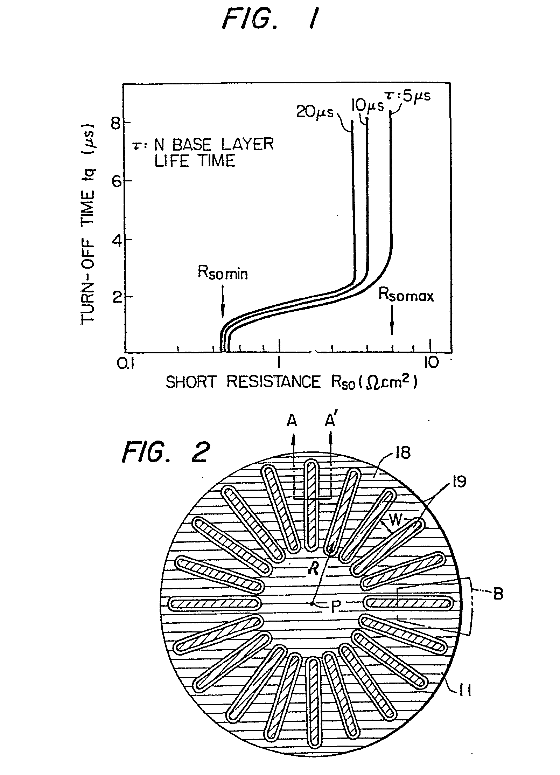

Fig. 1 shows the relationship between the emitter short-circuiting resistance $R_{so}$ and the turn-off time $t_q$ with the life time of carriers in the first base layer as a parameter. $R_{somin}$ represents the minimum value at which the thyristor can retain the conductive state, and $R_{somax}$ represents the maximum value at which the GTO thyristor is allowed to be turned off. Thus, there exists a band of values of $R_{so}$ in which the thyristor can be operated. The shapes, resistivities and thicknesses of the emitter layer on the anode side and of the emitter short-circuiting layer are selected so that the thyristor may operate within this given range.

With a conventional emitter short-circuited GTO thyristor, however, the turn-off time is, as described above, non-uniform through a GTO unit. In addition it has been found difficult to construct an emitter short-circuited GTO thyristor having a large power handling capacity.

Fig. 2 shows a basic pattern on the cathode side of a GTO thyristor of the type in which the emitter on the anode side is short-circuited according to the present invention. A semiconductor composite body or element 11 is formed in a circular shape. As will be described hereafter, the emitter layer on the cathode side, which serves as a second outer semiconductor layer, is formed as a plurality of elongate substantially strip-shaped units which extend radially. Cathode electrodes 19 are formed on the emitter layer on the cathode side. Similarly, a control electrode 18 is formed on a second base layer which serves as a second inner semiconductor layer described later and which is exposed on the main surface on the cathode side of the semiconductor body or element. A connection point P which is connected to an external lead wire described later is situated at the centre of the control electrode 18, i.e. at the centre of the element 11. Thus, this GTO thyristor has a so-called centre gate construction. In Fig. 2, there are twenty cathode electrodes 19, i.e. the thyristor has 20 GTO units.

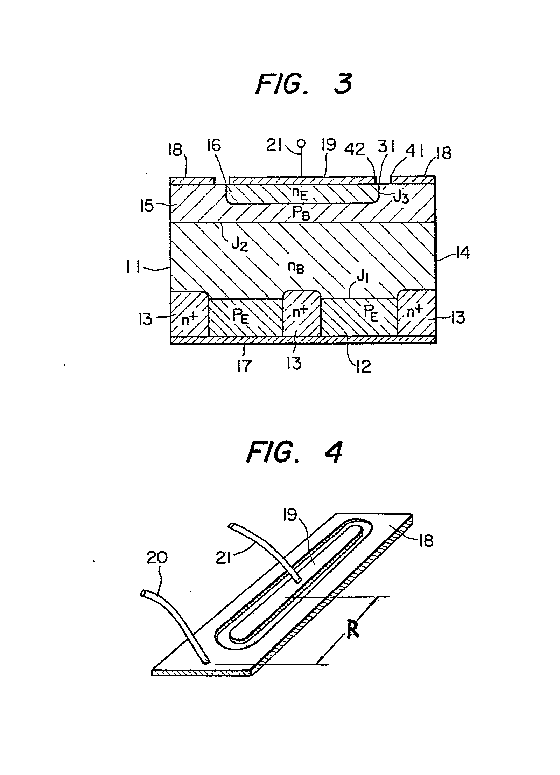

Fig. 3 shows how the semiconductor composite element 11 consists of four layers, i.e. a first outer semiconductor layer or emitter layer 12 of P-type (or N-type) on the anode side, a first inner semiconductor layer or first base layer 14 of N-type (or P-type), a second inner semiconductor layer or second base layer 15 of P-type (or N-type) and a second outer semiconductor layer or emitter layer 16 of N-type (or P-type) on the cathode side.

A portion of the first base layer 14 is brought into contact with an anode electrode 17 via an emitter short-circuiting layer 13 of $N^+$-type (or $P^+$-type) on the anode side. The anode electrode 17 also contacts the emitter layer 12. The second base layer 15 and the emitter layer 16 on the cathode side are, respectively, in contact with the control electrode 18 and the cathode electrode 19.

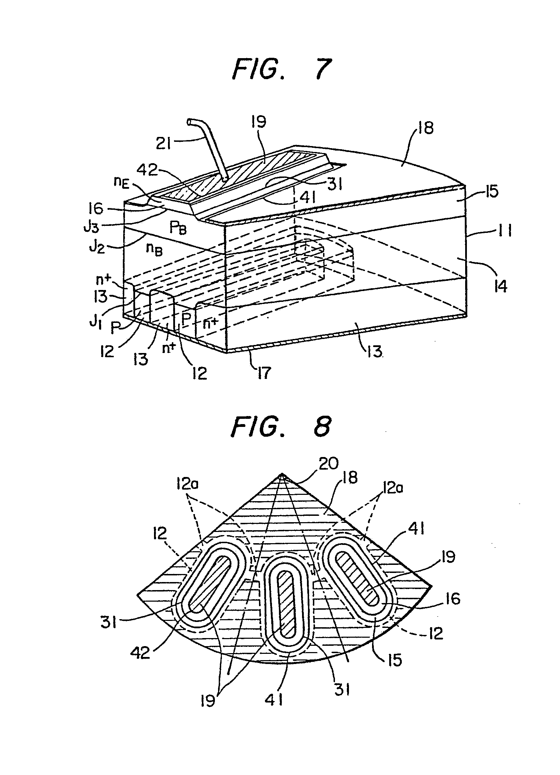

In more detail, the emitter layer 16 on the cathode side has a so-called planar junction in which an end or edge of PN junction 31 is exposed at the upper main surface of the element 11. The emitter layer 12 on the anode side is formed in areas defined by the projection of the units of the emitter layer 16 onto the anode side, more specifically the projection of the exposed edges of the PN junction 31. Thus the layer 12 is likewise divided into a plurality of elongate radially extending units. These units of the layer 12 are thus separated by regions of the layer 13 which, in plan view, have wedge or fan shapes (see Fig. 7 below). In this embodiment, there are also regions of the layer 13 beneath units of the layer 16.

The lead wire 21 is connected to the cathode electrode 19. Edges 41 and 42 of the control electrode 18 and the cathode electrode 19, respectively, are shown. $J_1$, $J_2$ and $J_3$ denote the PN junctions.

The basic principle of the operation of the GTO unit shown in Fig. 3 is now described. The provision of the emitter short-circuiting layer 13 on the anode side causes the current amplification factor (Alpha) of the transistor including the emitter layer 12 to be substantially decreased, and enables the carriers accumulated in the first base layer 14 to be driven into the anode electrode 17. Therefore, the carriers in the first base layer 14 can be caused to be quickly extinguished when the gate signal for turn-off is applied, thus giving good turn-off characteristics even when the life time of the carriers in the first base layer 14 is long, by suitably selecting the emitter short-circuiting resistance $R_{so}$ in accordance with the equation (1). Furthermore, the carriers accumulated in the first base layer 14 can be driven away more quickly if the emitter layer 16 and the emitter short-circuiting layer 13 on the anode side in the GTO thyristor are formed in particular shapes, and if the lead wire connected to the control electrode 18 is provided at a predetermined position, as will be described hereafter.

In order to produce devices having increased blocking voltage as well as increased current capacity, it is recommended that a circular element 11 as shown in Fig. 2 is employed so that the electric field in the periphery of the element is not increased and the effective area of the element is increased.

The electrical resistance of the control electrode 18 is discussed first.

With the external lead wire at the centre P of the control electrode 18, the width W (Fig. 2) of the control electrode 18 between the GTO units is for example several hundred $\mu$m, and the electrical resistance in the radial direction r is not negligible.

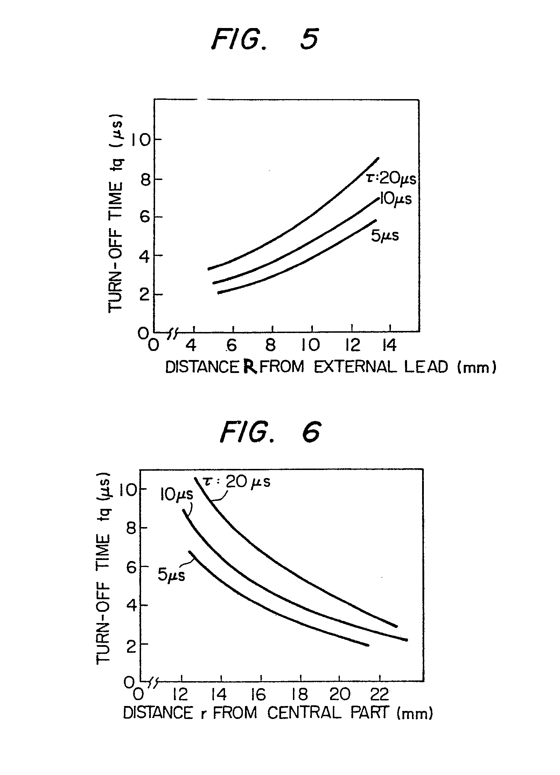

In general, the gate lead wire is connected to the control electrode by welding an end of the wire 20 onto a portion of the control electrode 18 as shown in Fig. 4. The extent to which the accumulated carriers are extracted from the second base layer 15 varies with the distance R from the point where the external lead wire 20 is welded onto the control electrode 18. The turn-off time tends to increase with the increase in the distance R from the external lead wire. Fig. 5 illustrates this, showing that the turn-off time ($\mu$s) of the GTO thyristor increases with the increase in the distance R (mm) from the connection point P, though it varies slightly with the carrier life time $\tau$ of the first base layer. Accordingly, the turn-off time of a region of the first base layer 14 remote from the connection point is longer than that of a region close to the connection point.

On the other hand, the units of the emitter layer 12 on the anode side are formed at areas defined by the projection of the units of the emitter layer 16 and also have a radially elongate substantially rectangular plan view.

Fig. 7, therefore, shows how the emitter short-circuiting layer 13 on the anode side has fan or wedge shape regions whose area per unit length increases from the centre toward the periphery of the element 11. These regions are located in the circumferential direction between the areas of projection of the units of the layer 16 onto the anode side. This increase in the area per unit length of those regions of the layer 13 with distance from the centre is proportional to the decrease in the resistance of the layer 13, and provides an increased emitter short-circuiting effect.

As described previously, as the emitter short-circuiting effect increases, the extraction of the accumulated carriers is increased correspondingly so that the turn-off time is shortened. Fig. 6 shows that the effect of the wedge-shaped regions is to decrease the turn-off time $t_q$ with increase in the distance r, so that the emitter short-circuiting layer 13 on the side of the anode of the present invention produces characteristics which are the opposite of the characteristics shown in Fig. 5.

Therefore, by compensating for the characteristics shown in Fig. 5 which stem from the elongate radial emitter layer units 16 by means of the characteristics shown in Fig. 6 which stem from the shape of the emitter short-circuiting layer 13, it is possible to obtain uniform turn-off times anywhere in the semiconductor composite element 11 irrespective of whether one considers the central or the peripheral portions. Consequently, with a GTO thyristor according to the present invention, the gate turn off operation can be performed uniformly throughout the entire semiconductor element 11.

Accordingly, the current does not flow in a concentrated manner when the gate signal for turn-off is applied, and thus the element is not thermally destroyed.

The turn-off time of the device is determined by suitably selecting the width W and length of the control electrode 18, and the mitter short-circuiting resistance $R_{so}$.

The external lead wire 20 is connected onto the control electrode 18 in a manner shown in Fig. 4, at the centre of the semiconductor element 11 which is not shown in Fig. 7. In Fig. 7, steps are formed by etching in the main surfaces of the second base layer 15 and the emitter layer 16 on the cathode side. A PN junction 31 formed by the second base layer 15 and the emitter layer 16 is exposed as part of a stepped region (mesa region). The emitter layers 12 on the anode side are present in the regions determined by the projection of the exposed ends of the emitter layers on the cathode side onto the anode side. Since the units of the emitter layer 12 on the anode side are formed in nearly the same shape as the units of the emitter layer 16 on the cathode side which are elongate and radial the area per unit length in the radial direction of the regions of the emitter short-circuiting layer 13 which are not beneath the units of the layer 16 increases from the centre toward the periphery.

Details of embodiments of the invention will now be given.

The semiconductor composite element or substrate 11 has a diameter of 30 mm, and the silicon wafer which is its starting material has a resistivity of 50 ohms · cm and a thickness of 0.3 mm. The emitter layer 12, the emitter short-circuiting layer 13, the second base layer 15 and the emitter layer 16 have impurity concentrations of $5 \times 10^{18}$, $1 \times 10^{20}$, $5 \times 10^{18}$, and $1 \times 10^{20}$ atoms/cm$^3$ respectively, at the surfaces of the element 11.

The units of the emitter layer 16 extend radially outwardly from a distance from the centre of one-half the radius of the element 11, and each have a width of 200 $\mu$m and a length of 7 mm. The units of the emitter layer 12 on the other hand have a width of 200 $\mu$m and a length of 7.5 mm. The wedge-shaped regions of the emitter short-circuiting layer 13 have a width of about 0.6 mm at their ends close to the centre and a width of about 1.7 mm at the peripheral portion within a fan-shaped portion, while the regions of the layer 13 immediately below the units of the emitter layers 16 on the cathode side have a width of 0.03 mm. These lengths are all as measured in the portions where the emitter layers 16 on the cathode are projected. 72 GTO units are formed in the element 11.

The turn-off time of the GTO thyristor constructed in the above manner was 3 $\mu$s at a rated current of 300 amp.

Fig. 8 shows a pattern of three GTO units, viewed from the anode side in another embodiment. Solid lines indicate semiconductor layers 15, 16 on the cathode side, as well as electrodes 18, 19. Dotted lines indicate semiconductor layers 12 on the anode side and short-circuiting bridge portions 12a.

In the embodiment shown in Fig. 7, the emitter layers 12 are independent and separate from each other. In the embodiment of Fig. 8, however, the emitter layers 12 are connected together by the bridge portions 12a, so that when a gate signal is applied to switch the unit on, a given GTO unit is rendered conductive and the conductive state then spreads to other GTO units through the portions 12a, so that the device as a whole is quickly turned on.

In Fig. 8, lines 31 show where the edges or ends of the PN junctions formed by the second base layer 15 and the emitter layers 16 are exposed at the main surface on the cathode side. The external lead wire is connected to the control electrodes 18 at 20.

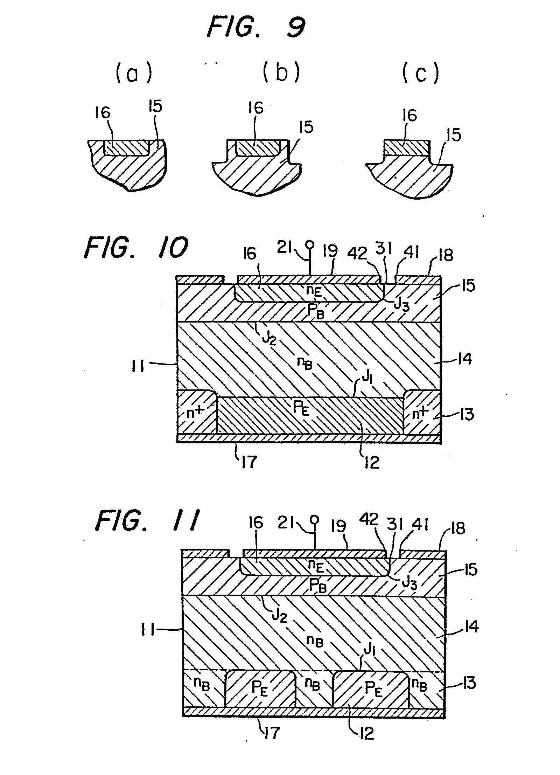

Diagrams (a) to (c) of Fig. 9 illustrate various arrangements of the main surface on the cathode side. Diagram (a) shows the end of the PN junction formed by the second base layer 15 and the emitter layer 16 exposed at a flat main surface region. Diagram (b) shows the end of this PN junction exposed at the upper face of a stepped portion of the main surface. Diagram (c) shows a stepped portion formed in the main surface, with the end of this PN junction exposed at the steps.

In the arrangements of diagrams (b) and (c) of Fig. 9, a post like electrode which can be placed on the cathode side can be forced into contact with the emitter electrodes 19 while the second base layer 15 can be easily insulated from the emitter layer 16.

In the embodiment of Fig. 10, the emitter layer 12 on the anode side extends over the entire area of the projection of the emitter layer 16 onto the cathode side. This GTO thyristor is suitable when the emitter layer 16 is of small width.

The pattern of the anode side will be determined according to the turn-off time $t_q$ required and the emitter short-circuiting resistance $R_{so}$ as mentioned earlier.

Fig. 11 illustrates a further embodiment in which the first base layer 14 and the emitter short-circuiting layers 13 have the same conductivity type as well as the same impurity concentration. This GTO thyristor is suitable when the emitter layer 16 is of large width.

Thus in devices of the present invention as described above, it is possible for the accumulated carriers to be uniformly extracted throughout the entire surface of the semiconductor substrate, so that the device can be turned off uniformly without the current being concentrated in any one region, thus enabling a good turn-off operation to be accomplished. Since the current does not concentrate in any one region the power handling capacity of the GTO thyristor can easily be increased.

## Claims

1. A gate turn-off thyristor comprising:

(a) a semiconductor body (11) having first and second main surfaces,

(b) four semiconductor layers in said body (11) which layers are a first inner layer (13, 14) and a second inner layer (15) contiguous with each other, and a first outer layer (12) and a second outer layer (16) which are respectively contiguous with said first and second inner layers and are exposed respectively at said first and second main surfaces, said second outer layer (16) being, as seen in plan view onto the said second main surface, surrounded by said second inner layer (15), and the conductivity type of each said layer being different from the conductivity type of the or each contiguous layer,

(c) an anode electrode (17) on said first main surface and in contact with said first outer layer (12),

(d) a cathode electrode (19) on said second main surface and in contact with said second outer layer (16), and

(e) a control electrode (18) on said second main surface and in contact with said second inner layer (15),

(f) said second outer layer (16) being divided into a plurality of elongate units,

(g) said first outer layer (12) being likewise divided into a plurality of elongate units located at the areas of the projection of the said units of the second outer layer (16) onto said first main surface, and

(h) said first inner layer having a first portion or portions (13) which provide part of said first main surface and contact the anode, and a second portion (14) which is contiguous with said first outer layer (12) on the inner side thereof and is separated from said first main surface by said first portion or portions (13), characterised in that:

(i) said first portion or portions (13) of the first inner layer are shaped so as to surround (as seen in plan view) the said units of the first outer layer (12) at said first surface and to have elongate regions which are respectively located (as seen in plan view) between the said units of the first outer layer (12) and which (as seen in plan view) increase in width per unit length in the direction of their elongation from first ends of the said units of the first outer layer (12) to second ends of those units, and

(j) a control electrode connection member (20) is connected to said control electrode (18) at a point spaced away from first ends of said elongate units of said second outer layer, which first ends correspond in plan view to said first ends of said units of said first outer layer, in the opposite direction to the direction of elongation of said units of said second outer layer from said first ends thereof to second ends thereof.

2. A gate turn-off thyristor according to claim 1, wherein said units of said second outer layer (16) are arranged radially, and said first inner layer (13, 14) is exposed at said first main surface such that the area per unit length of said first inner layer exposed at said first main surface increases in the longitudinal direction of said first outer layer unit (12) from a point adjacent the center of said radial arrangement towards the periphery of said radial arrangement.

3. A gate turn-off thyristor according to claim 2, wherein each of said main surfaces of said semiconductor substrate are circular in plan view.

4. A gate-turn off thyristor according to any one of claims 1 to 3, wherein said first inner layer (13) further comprises a plurality of third portions respectively positioned (as seen in plan view) surrounded by said elongate regions of the first outer layer (12) and in ohmic contact with said anode (17).

5. A gate turn-off thyristor according to any one of claims 1 to 4, wherein the resistivity of said first portion or portions (13) of the first inner layer is lower than that of said second portion (14) of the first inner layer.

6. A gate turn-off thyristor according to claim 5, wherein said first portion or portions (13) of said first inner layer projects away from said first outer surface a distance greater than the projection of said first outer layer from that outer surface.

7. A gate turn-off thyristor according to any one of claims 1 to 6, wherein said second major surface is recessed at the exposed surface regions of said second inner layer (15), where said gate electrode (18) is disposed.

8. A gate turn-off thyristor according to any one of claims 1 to 7, wherein said semiconductor substrate has further semiconductor regions (12a) of the same conductivity type as said first outer layer (12), which further regions (12a) are of strip shapes and represent bridge portions to interconnect said first outer layer units (12) respectively.

9. A gate turn-off thyristor according to claim 2, wherein the control electrode connection member (20) is electrically connected to said control electrode (18) at or close to said center of said radial arrangement, and a pair of connection members are electrically connected to said cathode (19) and said anode (17) respectively.

**Revendications**

1. Thyristor à grille de commande comportant:

(a) un corps semiconducteur (11) possédant une première et une seconde surfaces principales,

(b) quatre couches semiconductrices situées dans ledit corps (11) qui sont constituées par une première couche intérieure (13, 14) et par une seconde couche intérieure (15) contiguës entre elles, et par une première couche extérieure (12) et par une seconde couche extérieure (16), qui sont respectivement contiguës auxdites première et seconde couches intérieures et sont mises à nu respectivement au niveau desdites première et seconde surfaces principales, ladite seconde couche extérieure (16) étant entourée par ladite seconde couche intérieure (15) lorsqu'on regarde selon une vue en plan ladite seconde surface principale, et le type de conductivité de chacune desdites couches étant différent du type de conductivité de la ou de chaque couche contiguë,

(c) une électrode d'anode (17) située sur ladite première surface principale et se trouvant en contact avec ladite première couche extérieure (12),

(d) une électrode de cathode (19) située sur ladite seconde surface principale et se trouvant en contact avec ladite seconde couche extérieure (16), et

(e) une électrode de commande (18) située sur ladite seconde surface principale et se trouvant en contact avec ladite seconde couche intérieure (15),

(f) ladite seconde couche extérieure (16) étant subdivisée en une pluralité d'unités allongées,

(g) ladite première couche extérieure (12) étant de façon analogue subdivisée en une pluralité d'unités allongées situées dans les zones de projection desdites unités de la seconde couche (16) sur ladite première surface principale, et

(h) ladite première couche intérieure possédant une ou des premières parties (13) qui forment une partie de la première surface principale et qui contactent l'anode, et une seconde partie (14) qui est contiguë à ladite première couche extérieure (12) sur la face intérieure de cette dernière et est séparée de ladite première surface principale par la ou lesdites premières parties (13),

caractérisé en ce que:

(i) la ou lesdites premières parties (13) de la première couche inférieure sont conformées de manière à entourer (selon une vue en plan) lesdites unités de ladite première couche extérieure (12) sur ladite première surface et à posséder des régions allongées qui sont situées respectivement (selon une vue en plan) entre lesdites unités de la première couche extérieure (12) et dont la largeur par unité de longueur augmente (selon une vue en plan) suivant la direction de leur étendue à partir des premières extrémités desdites unités de la première couche extérieure (12) en direction des secondes extrémités de ces unités,

(j) qu'un organe (20) de raccordement de l'électrode de commande est raccordé à ladite électrode de commande (18) en un point distant des premières extrémités des unités allongées de ladite seconde couche extérieure, qui correspondent, selon une vue en plan, auxdites premières extrémités desdites unités de ladite première couche extérieure, suivant la direction opposée à la direction selon laquelle les unités de ladite seconde couche extérieure s'étendent depuis lesdites premières extrémités jusqu'à des secondes extrémités de cette couche.

2. Thyristor à grille de commande selon la revendication 1, dans lequel lesdites unités de ladite seconde couche extérieure (16) sont disposées radialement et dans lequel ladite première couche intérieure (13, 14) est mise à nu au niveau de ladite première surface principale de telle sorte que la surface par unité de longueur de la première couche intérieure mise à nu au niveau de ladite première surface principale augmente suitant la direction longitudinale de ladite première couche extérieure (12) depuis un point voisin du centre dudit agencement radial en direction du pourtour de cet agencement.

3. Thyristor à grille de commande suivant la revendication 2, dans lequel chacune desdites surfaces principales dudit substrat semiconducteur est circulaire selon une vue en plan.

4. Thyristor à grille de commande selon l'une quelconque des revendications 1 à 3, dans lequel ladite première couche intérieure (13) comporte en outre une pluralité de troisièmes parties respectivement positionnées (selon une vue en plan) en étant entourées par lesdites régions allongées de la première couche extérieure (12) et en étant en contact ohmique avec ladite anode (17).

5. Thyristor à grille de commande selon l'une quelconque des revendications 1 à 4, dans lequel la résistivité de la ou desdites premières parties (13) de la première couche inférieure est inférieure à celle de la seconde partie (14) de la première couche intérieure.

6. Thyristor à grille de commande selon la revendication 5, dans lequel la ou lesdites premières parties (13) de ladite première couche extérieure font saillie à partir de la première surface extérieure à une distance supérieure à la projection de ladite première couche extérieure à partir de cette surface extérieure.

7. Thyristor à grille de commande selon l'une quelconque des revendications 1 à 6, dans lequel ladite seconde surface principale est en renfoncement au niveau des régions de la surface à nu de ladite couche intérieure (15), où ladite électrode de grille (18) est disposée.

8. Thyristor à grille de commande selon l'une quelconque des revendications 1 à 7, dans laquelle ledit substrat semiconducteur possède des régions semiconductrices supplémentaires (12a) possédant le même type de conductivité que ladite première couche extérieure (12), lesquelles régions (12a) possède la forme de bandes et représentent des parties en forme de ponts servant à réaliser une interconnexion avec lesdites unités (12) de la première couche extérieure.

9. Thyristor à grille de commande selon la revendication 2, caractérisé en ce que l'organe (20) de raccordement de l'électrode de commande est raccordé électriquement à ladite électrode de commande (20) au centre ou à proximité dudit centre dudit agencement radial, et qu'un couple d'organes de raccordement sont raccordés électriquement à ladite cathode (19) et à ladite anode (17).

**Patentansprüche**

1. Abschaltthyristor, umfassend
(a) einen Halbleiterkörper (11) mit einer ersten und einer zweiten Hauptfläche,
(b) vier in dem Körper (11) vorhandene Halbleiterschichten, die eine ersten Innenschicht (13, 14) und eine an diese angrenzende zweite Innenschicht (15) sowie eine erste Außenschicht (12) und eine zweite Außenschicht (16) sind, wobei die Außenschichten an die erste bzw. die zweite Innenschicht angrenzen und an der ersten bzw. der zweiten Hauptfläche freiliegen, wobei die zweite Außenschicht (16), in Draufsicht auf die zweite Hauptfläche gesehen, von der zweiten Innenschicht (15) umgeben ist, und wobei der Leitfähigkeitstyp jeder der besagten Schichten vom Leitfähigkeitstyp der bzw. jeder angrenzenden Schicht verschieden ist,
(c) eine auf der ersten Hauptfläche und in Kontakt mit der ersten Außenschicht (12) befindliche Anodenelektrode (17),

(d) eine auf der zweiten Hauptfläche und in Kontakt mit der zweiten Außenschicht (16) befindliche Kathodenelektrode (19), und

(e) eine auf der zweiten Hauptfläche und in Kontakt mit der zweiten Innenschicht (15) befindliche Steuerelektrode (18),

(f) wobei die zweite Außenschicht (16) in eine Vielzahl von länglichen Einheiten unterteilt ist,

(g) wobei die erste Außenschicht (12) in gleicher Weise in eine Vielzahl von länglichen Einheiten unterteilt ist, die in den Projektionsflächen der Einheiten der zweiten Außenschicht (16) auf die erste Hauptfläche angeordnet sind, und

(h) wobei die erste Innenschicht einen Abschnitt oder Abschnitte (13), die Teil der ersten Hauptfläche bilden und die Anode kontaktieren, und einen zweiten Abschnitt (14) aufweist, der an die erste Außenschicht (12) an deren Innenseite angrenzt und von der ersten Hauptfläche durch den ersten Abschnitt bzw. die ersten Abschnitte (13) getrennt ist,

dadurch gekennzeichnet,

(i) daß der erste Abschnitt bzw. die ersten Abschnitte (13) der ersten Innenschicht so gestaltet sind, daß sie (in Draufsicht gesehen) die besagten Einheiten der ersten Außenschicht (12) an der ersten Fläche umgeben und längliche Bereiche aufweisen, die (in Draufsicht gesehen) jeweils zwischen den Einheiten der ersten Außenschicht (12) angeordnet sind und (in Draufsicht gesehen) in Richtung ihrer länglichen Erstreckung von ersten Enden der Einheiten der ersten Außenschicht (12) zu zweiten Enden dieser Einheiten in der Breite pro Längeneinheit zunehmen, und

(j) daß ein Steuerelektroden-Anschlußelement (20) mit der Steuerelektrode (18) an einer Stelle verbunden ist, die von den ersten Enden der Einheiten der ersten Außenschicht in der Draufsicht entsprechenden ersten Enden der länglichen Einheiten der zweiten Außenschicht in einer Richtung entfernt sind, die zur Richtung der länglichen Erstreckung der Einheiten der zweiten Außenschicht von ihren ersten zu ihren zweiten Enden entgegengesetzt ist.

2. Abschaltthyristor nach Anspruch 1, wobei die Einheiten der zweiten Außenschicht (16) radial angeordnet sind und die erste Innenschicht (13, 14) an der ersten Hauptfläche derart freiliegt, daß die an der ersten Hauptfläche freiliegende Fläche pro Längeneinheit der ersten Innenschicht in Längsrichtung der ersten Außenschicht-Einheit (12) von einer Stelle nahe den Zentren der radialen Anordnung in Richtung des Randes der radialen Anordnung zunimmt.

3. Abschaltthyristor nach Anspruch 2, wobei jeder der Hauptflächen des Halbleitersubstrats in der Draufsicht kreisförmig ist.

4. Abschaltthyristor nach einem der Ansprüche 1 bis 3, wobei die erste Inneschicht (13) ferner eine Vielzahl von dritten Abschnitten umfaßt, die jeweils so angeordnet sind, daß sie (in Draufsicht gesehen) von den länglichen Bereichen der ersten Außenschicht (12) umgeben sind und oh Ohm'schem Kontakt mit der Anode (17) stehen.

5. Abschaltthyristor nach einem der Ansprüche 1 bis 4, wobei der spezifische Widerstand des ersten Abschnitts bzw. der ersten Abschnitte (13) der ersten Innenschicht niedriger ist als der des zweiten Abschnitts (14) der ersten Innenschicht.

6. Abschaltthyristor nach Anspruch 5, wobei der erste Abschnitt bzw. die ersten Abschnitten (13) der ersten Innenschicht von der ersten Außenfläche um ein Maß vorspringt, das größer ist als der Vorsprung der ersten Außenschicht von der ersten Außenfläche.

7. Abschaltthyristor nach einem der Ansprüche 1 bis 6, wobei die zweite Hauptfläche an den freiliegenden Flächenbereichen der zweiten Innenschicht (15), wo die Steuerelektrode (18) angeordnet ist, vertieft ist.

8. Abschaltthyristor nach einem der Ansprüche 1 bis 7, wobei das Halbleitersubstrat weitere Halbleiterbereiche (12a) vom gleichen Leitfähigkeitstyp wie die erste Außenschicht (12) aufweist, die streifenförmig sind und Brückenabschnitte zur jeweiligen Verbindung der ersten Außenschicht-Einheiten (12) darstellen.

9. Abschaltthyristor nach Anspruch 2, wobei das Steuerelektrode-Anschlußelement (20) mit der Steuerelektrode (18) in oder nahe den Zentrum der radialen Anordnung verbunden ist und ein Paar von Anschlußelementen mit der Kathode (19) bzw. der Anode (17) elektrisch verbunden sind.

## FIG. 1

## FIG. 2

# FIG. 3

# FIG. 4

## FIG. 5

## FIG. 6

## FIG. 7

## FIG. 8

## FIG. 9

(a)     (b)     (c)

## FIG. 10

## FIG. 11